# EUROPEAN PATENT SPECIFICATION

(11) **EP 0 456 288 B1**
(45) Date of publication and mention of the grant of the patent: **05.07.1995**
(21) Application number: 91200753.1
(22) Date of filing: 29.03.1991
(51) Int. Cl.: H05K 13/00

(54) **Tray-shaped element for packing of printed circuit boards**
Schalenförmiges Element zur Verpackung von gedruckten Leiterplatten
Elément en forme de plateau pour emballer des plaques de circuit imprimé

(30) Priority: 11.05.1990 IT 2115990
(43) Date of publication of application: 13.11.1991
(73) Proprietor: ITALTEL SOCIETA ITALIANA TELECOMUNICAZIONI s.p.a., 20149 Milano (IT)
(72) Inventor: Fusi, Natale, I-20080 Cisliano (MI) (IT); Azzoli, Francesco, I-20010 Canegrate (MI) (IT)
(74) Representative: Giustini, Delio

(56) References cited:
- US-A- 4 593 813
- IBM TECHNICAL DISCLOSURE BULLETIN. vol. 23, no. 7A, December 1980, NEW YORK USpages 2655 - 2656; T.A. ANZELONE: "EQUIPMENT TRAYS FOR HANDLING CERAMICGREENSHEETS"

## Description

The present invention refers to a tray-shaped element, essentially rectangular in shape, suitable to form one half of a packaging box for printed circuit boards, see e.g. US-A-4 593 813.

The transport of printed circuit boards, particularly of boards already assembled with the components, is a step required for instance, when repairing any equipment by replacing the faulty or malfunctioning boards. In these cases the board is disconnected and removed from the equipment to be sent to repair, generally using the same box used for the transport of the spare board.

Boxes of the known type for this application are generally made of paper boxes which offer poor protection guaranties during shipment or transport and are scarcely fit to be employed at the workshop since they tend to slide one on the other when they are piled up. Furthermore these boxes present some problems due to their limited stoutness, particularly if destined to higher size boards, as for instance those called 6 U, where U indicates the basic unit of 250 x 420 cm. Moreover the boxes are cumbersome, particularly when they are not used to house a board.

The purpose of the present invention is to overcome the above indicated inconveniences, and in particular to carry out a dismountable box for printed circuit boards formed connecting two tray-shaped elements between them, said elements being of stout and economical construction, and partially stackable, either when they are not used or when they are assembled to form a container.

This purpose is attained with the features of claim 1.

Further advantageous characteristics form the object of the dependent claims.

The invention shall now be described making reference to the enclosed drawings, where:
Fig. 1 is a plan view of the tray element according to the invention, showing the portion destined to form the inside of the whole container;
Fig. 2 is a section according to line II-II of Fig. 1, shown together with another tray element, superimposed to form a container;
Fig. 3 is a section according to the line III-III of Fig. 1, shown together with another piled up tray element;
Fig. 4 is a plan view showing the outside of the tray element;
Fig. 5 is a partial section, expanded scale, according to the line V-V of Fig.1;
Fig. 6 is a partial section, expanded scale, according to the line VI-VI of Fig. 1; and

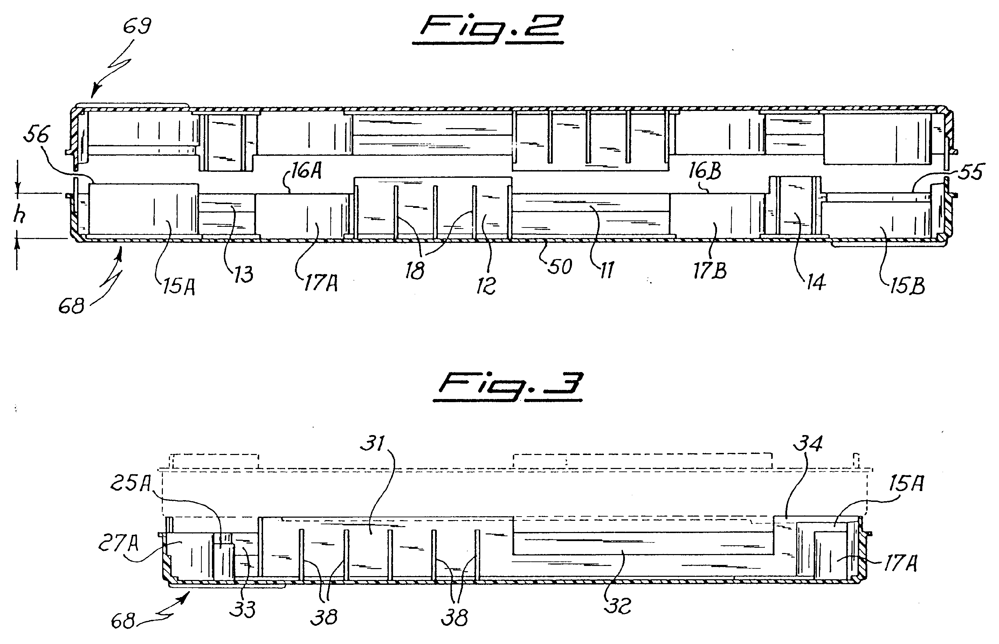

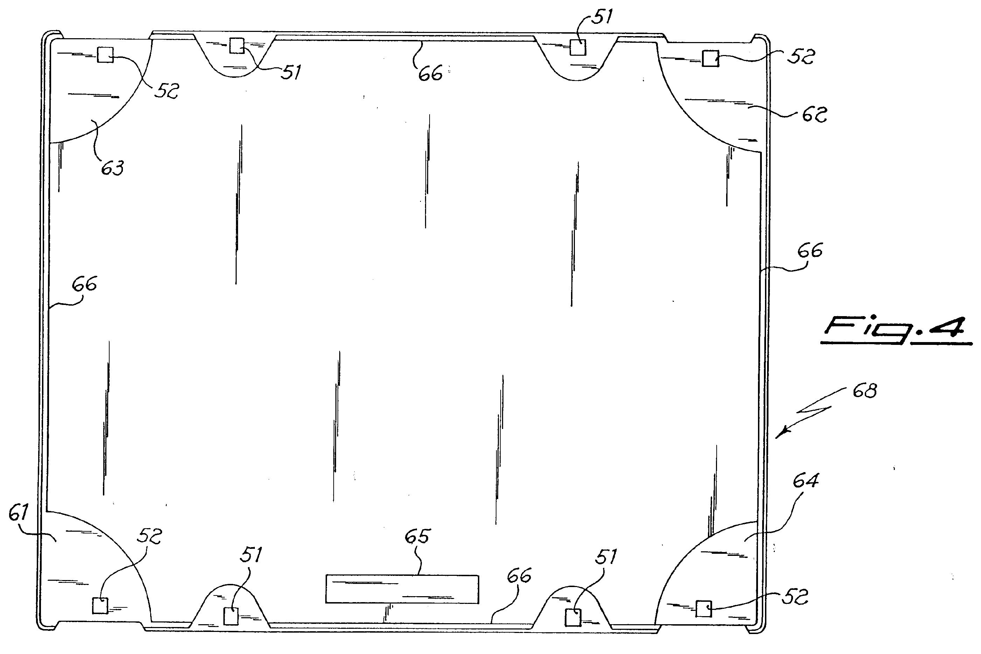

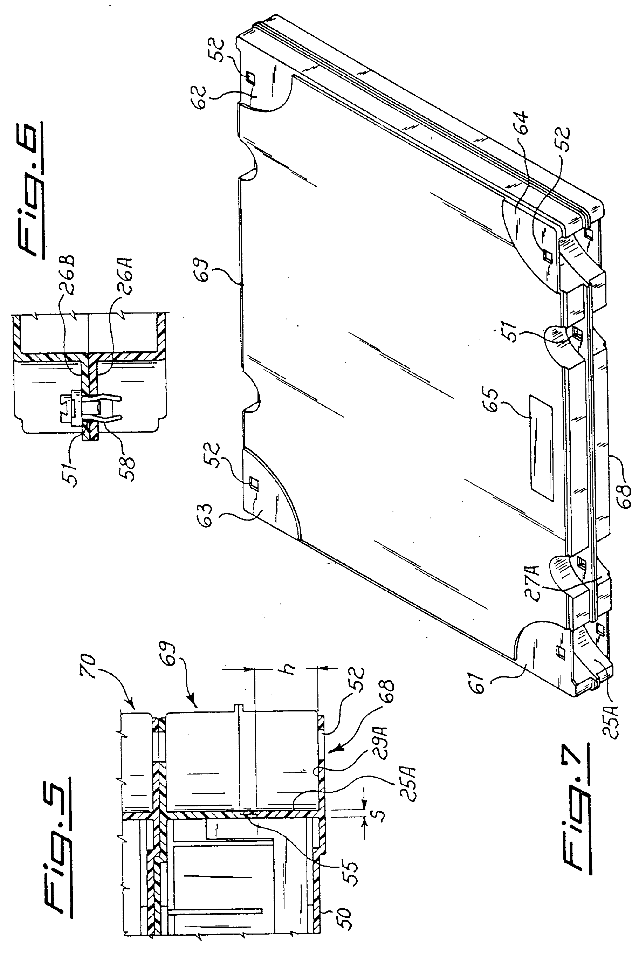

Fig. 7 is a perspective showing the assembled container.

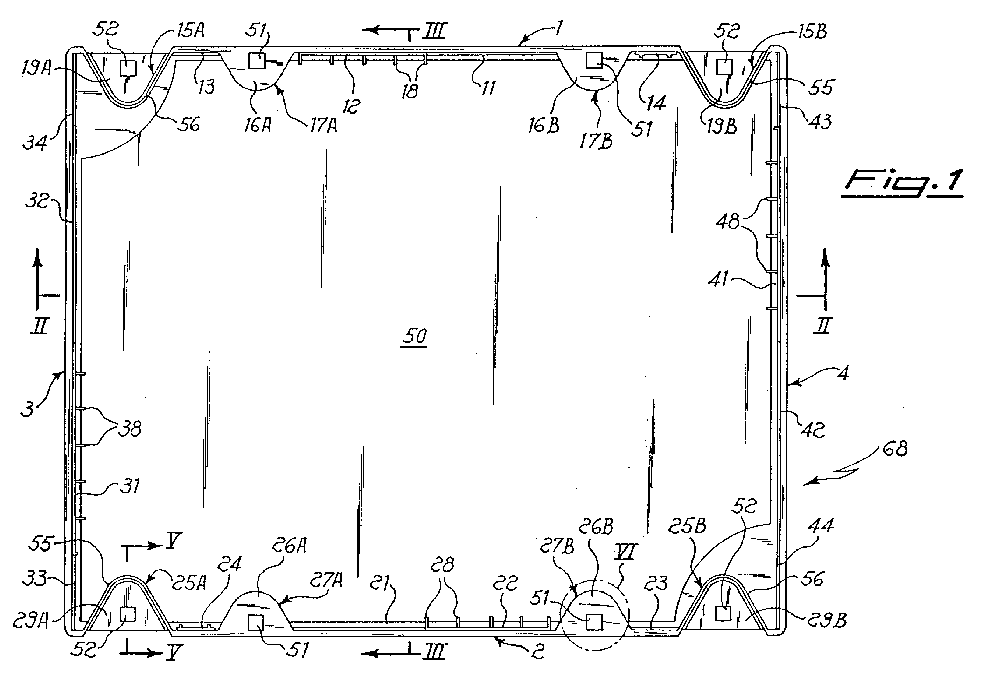

Making reference to the figures and particularly to Fig. 1, the invention includes an element 68 rectangular tray shaped, preferably obtained by plastics moulding.

This element includes a bottom board 50, equipped on one side of lateral walls 1,2,3,4 extending along the whole perimeter of the board 50, with the walls 1 and 2 placed on the longer sides. Moreover, on the face from which lateral walls rise (called also internal face for the reasons which will become clear when described below) a net of thin and low ribs is foreseen, which are not shown on the drawing not to embroil uselessly the drawing itself.

The wall thickness is not constant and, for our sake, an average thickness s is defined (Fig. 5), corresponding to the lower length of the wall, that is close to the bottom board, which is not involved in modifications made in the rest portion of the wall.

In the same way, always referring to Fig. 5, an avergae height h is defined corresponding to an element profile which, in the formation of a container, comes in contact with the other element along the whole perimeter of the walls.

Referring also to Fig. 2, wall 1 foresees, in the center length a straight indentation 11 in the wall thickness and an adjacent straight projection 12 raising over the profile or average height h of wall 1. The projection 11 and the adjacent indentation 12 have equal length. Furthermore, as all other indentations and projections foreseen by the invention, they have equal height, meaning by this that the length of indentation 11 towards the base board 50 is equal to the length of projection 12 over height h.

The wall foresees futhermore stiffening ribs 18 facing the straight projection, extending from the base board 50.

Wall 1 foresees a further straight indentation 13 and a further straight projection 14, having length equal and lower of the one of parts 11, 12.

Two pairs of curved indentations are also foreseen on wall 1 and more in particular two indentations 15A and 15B made close to the wall corners and two indentations 17A and 17B separating the adjacent parts 12, 11 from parts 13, 14. Curved indentations are obtained performing the wall according to an arch, e.g. a sinusoid.

Corner indentations 15A and 15B foresee flat closing portions 19A and 19B essentially forming an extension of the bottom board 50, while indentations 17A and 17B foresee flat closing portions 16A and 16B parallel to the bottom board 50. Flat portions 16A, 16B and 17A, 17B are equipped with rectangular or square openings, 51 and 52 respectively provided to cooperate with closing means of two tray coupled elements as it shall be better explained hereinafter.

The edge of the corner curved indentation 15A has a projection 56 raising over the average profile of the wall and is placed inside the tray element, while the edge of the curved indentation 15B foresees a groove 55 formed inward the tray element.

The opposite wall 2 foresees the same elements as wall 1, that is corner indentations 25A, 25B equipped with flat closing portions 29A, 29B, indentations 27A, 27B with closing portions 26A and 26B, and straight indentations 21 and 23, straight projections 22, 24 with each indentation on each wall facing a complementary projection of the opposite wall. Furthermore, corner indentations 25A, 25B foresee a curved indentation 55 and a curved projection 56, respectively, and holes 51, 52.

The curved indentation 25A is illustrated more in detail in the section of Fig. 5 showing also how to position another tray element 69 to form a container for printed circuit boards.

On the shorter side 3 a straight projection 31 and a straight indentation 32 are foreseen, adjacent and of equal length, adjacent in their turn to a further straight indentation 33 and to a straight projection 34. The two parts 33 and 34 have a length lower than parts 31 and 32, and the straight projection 34 is without stiffening ribs, while projection 31 foresees a series of stiffening ribs 38.

The other shorter side 4 foresees corresponding straight projections and indentations 41 and 42 adjacent and of equal length, adjacent in their turn to further straight indentations and projections 43 and 44, with projection 41 equipped with a series of stiffening ribs 48. In this case too, each indentation faces a groove of equal length and viceversa.

Referring to Fig. 6 in particular, on the other face, the tray element according to the invention shows two hollow portions and two raised portions 63 and 64 each one formed in correspondance of a corner and diagonally opposed, and two hollow portions 61 and 62 formed in correspondence of the other two corners. The shape of these portions is 90° part of circle. Furthermore the whole peripheral part of the tray is lowered for some millimeter width, as delimited by edge 66.

The external surface of board 50 preferably foresees a bay 65 obtained by molding, inside which are contained indications, marks, trade marks or other elements which could be directly obtained by molding, or labelled on the bay 65.

Thanks to the proposed configuration and as it can be seen in Fig. 2, two tray elements according to the invention 68, 69 can be assembled to form a case able to house a printed wire board and to enable a safety transport. The two elements are connected with hinge facing holes 51 of one side, by means of the known connection devices as shown in Fig. 6, or simply with fixing plastic clamps.

Particularly advantageous is the fact that the elements forming the case are identical and therefore they can be obtained with a single mould.

When not used, several of these trays, can be piled up if oriented in the same direction in order to reduce the storing space, and the single elements are kept in this position thanks to edge 66 which engages with the straight projections. This is clearly shown also in Fig. 3 where an element 67 dot-drawn has been superimposed to element 68.

Finally, it is possible to pile also containers formed by two tray elements, due to the presence of part of circle projections, this characteristic is useful for the transport of several printed circuit boards each one in its box. This is clearly shown in the detail of Fig. 5 where over the container 68-69, the lower element 70 of a further container has been superimposed.

Containers can be fixed among them for transport with plastic clamps passing through holes 52 and tightened.

## Claims

1. Tray shaped element, essentially rectangular, for the packing of printed circuit boards, including a bottom board (50) with side walls (1, 2, 3, 4) extending on one side and along the whole perimeter of the bottom board (50),
characterized by the fact that each wall (1, 2, 3, 4) foresees straight indentations (11, 13, 21; 32, 33, 42, 43) in the wall thickness and straight projections (12, 14, 22, 24; 31, 34, 41, 44) from the middle profile or wall height, each indentation on one wall facing a complementary projection on the opposite wall;
and by the provision of two pairs of curved indentations on two opposite walls, the indentations of the first pair (15A, 15B) being performed close to the corners of the wall and providing a flat portion (19A, 19B) essentially forming a part of the bottom board (50), while the indentations of the second pair (17A, 17B) have a flat portion (16A, 16B) parallel to the bottom board, said flat portion being provided with openings (51, 52) to cooperate with the closing means of two coupled elements.

2. Element according to claim 1, characterized by the provision, on the surface of the bottom board opposite to the one where walls rise, two hollow portions (61, 62) and two raised portions (63, 64) each one formed in correspondence of a corner and diagonally opposed.

3. Element according to claim 1 or 2, characterized by the fact that the edge of the two curved indentations (15A, 25B) diagonally opposed of said first pair forms a groove (55) protruding towards the inside of the tray element, while the edge of the other two curved indentations (15B, 25A) form a complementary projection (56) from the middle profile of the wall, placed at the inside the tray element.

4. Element according to claim 1, characterized by the fact that said two pair of curved indentations (15A, 15B; 17A, 17B and 25A, 25B; 27A, 27B) are provided on the longer sides of the tray and that between the curved indentations (17A, 17B) of said second pair a projection (12) and one indentation (11) are provided placed adjacent each other and of equal length, and that a further straight indentation (13), one straight projection (14) respectively, separates each curved indentation (17A, 17B) of said second pair from the corresponding corner curved indentation (15A, 15B).

5. Element according to claim 1, characterized by the fact that on each shorter side are provided with one projection (31, 41) and an indentation (32, 42) adjacent each other and of equal length, adjacent in their turn to a further straight indentation (33, 43) a straight projection (34,44) respectively.

6. Element according to claim 1, characterized by the fact that walls are provided with stiffening ribs (18, 38) facing said straight projections.

7. Element according to claim 2, characterized by the fact that said portions (61, 62, 63, 64) have the shape of 90° part of circle.

8. Element according to claim 2, characterized by the fact that, on the face opposite to the one where side walls rise, the whole tray peripheral edge is lowered in correspondence of an edge (66).

## Patentansprüche

1. Schalenförmiges, im wesentlichen rechteckiges Element zur Verpackung von gedruckten Leiterplatten, die eine Grundplatte (50) mit Seitenwänden (1, 2, 3, 4), die von jeweils einer Seite ausgehen und sich über den Gesamtumfang der Grundplatte (50) erstrecken,
dadurch gekennzeichnet, daß jede Seitenwand (1, 2, 3, 4) gerade Vertiefungen (11, 12, 21, 32, 33, 42, 43) in der Seitenwandstärke und gerade Vorsprünge (12, 14, 22, 24, 31, 34, 41, 44) vom mittleren Profil oder von der Seitenwandshöhe vorsieht, wobei jede Vertiefung auf einer Seitenwand einem ergänzenden Vorsprung auf der gegenüberliegenden Seitenwand gegenübersteht;
und dadurch, daß zwei Paare von gebogenen Vertiefungen auf den gegenüberliegenden Seitenwänden vorgesehen sind, wobei die Vertiefungen des ersten Paares (15A, 15B) nahe der Ecken der Seitenwand angebracht sind und eine abgeflachte Portion (19A, 19B) vorsehen, die im wesentlichen einen Teil der Grundplatte (50) bilden, während die Vertiefungen des zweiten Paares (17A, 17B) eine abgeflachte Portion (16A, 16B) parallel zur Bodenplatte aufweisen, und die genannte abgeflachte Portion ist mit Öffnungen (51, 52) versehen, welche die Verschlußvorrichtungen zweier gekoppelter Elemente ergänzen.

2. Element nach Anspruch 1, dadurch gekennzeichnet, daß es auf der Oberfläche der Grundplatte gegenüber der, auf der die Seitenflächen sich erheben, zwei Aushöhlungen (61, 62) und zwei Erhebungen (63, 64) aufweist, wobei jede in Übereinstimmung mit einer Ecke und diagonal gegenüberliegend angeordnet ist.

3. Element nach Anspruch 1 oder 2, dadurch gekennzeichnet, daß die Kante der beiden gebogenen Vertiefungen (15A, 25B), die diagonal dem genannten ersten Paar gegenüberliegt, eine Rille (55) bildet, die in Richtung auf die Innenseite des schalenförmigen Elements vorspringt, während die Kante der beiden anderen Vertiefungen (15B , 25B) einen ergänzenden Vorsprung (56) vom Mittelprofil der Wand an der Innenseite angeordnet bilden.

4. Element nach Anspruch 1, dadurch gekennzeichnet, daß die genannten beiden Paare gebogener Vertiefungen (15A, 15B; 17A, 17B, und 25A, 25b; 27A, 27B) auf den längeren Seiten der Schale vorgesehen sind und daß zwischen den gebogenen Vertiefungen (17A, 17B) des genannten zweiten Paares ein Vorsprung (12) und eine Vertiefung (11) vorgesehen sind, die angrenzend zu einander angeordnet sind und beide die gleiche Länge haben, und daß eine weitere gerade Vertiefung (13) beziehungsweise ein gerader Vorsprung (14) jede der gebogenen Vertiefungen (17A, 17B) des genannten zweiten Paares von der gebogenen Vertiefung (15A, 15B) der übereinstimmenden Ecke trennt.

5. Element nach Anspruch 1, dadurch gekennzeichnet, daß auf jeder der kürzeren Seiten ein Vorsprung (31, 41) und eine daran anliegende und gleichlange Vertiefung (32, 42) vorgesehen sind, die wiederum an eine weitere gerade Vertiefung (33, 43) beziehungsweise einen geraden Vorsprung (34, 44) angrenzen.

6. Element nach Anspruch 1, dadurch gekennzeichnet, daß die Seitenwände mit versteifenden Rippen (18, 38) versehen sind, die den genannten geraden Vorsprüngen gegenüberliegen.

7. Element nach Anspruch 2, dadurch gekennzeichnet, daß die genannten Portionen (61, 62, 63, 64) die Form eines 90° Teilkreises haben.

8. Element nach Anspruch 2, dadurch gekennzeichnet, daß die gesamte Schalenumfangkante in Übereinstimmung mit einer Kante (66) auf der Fläche, gegenüber der sich die Seitenwände erheben, herabgesetzt ist.

## Revendications

1. Elément en forme de plateau essentiellement rectangulaire pour l'emballage de plaques de circuit imprimé, comprenant une plaque de fond (50) avec des parois latérales (1, 2, 3, 4), qui s'étendent sur une paroi et le long du périmètre de la plaque de fond (50),
caractérisé en ce que chaque paroi (1, 2, 3, 4) prévoit des renfoncements droites (11, 13, 21, 32, 33, 42, 43) dans l'épaisseur de la paroi et des saillies droites (12, 14, 22, 24, 31, 34, 41, 44) du profile de milieu ou l'hauteur de la paroi, chaque renfoncement sur une paroi faisant face à une saillie complémentaire sur la paroi opposée;
et en ce qu'il y a deux pairs de renfoncements courbés sur deux parois opposées, les renfoncements de la première pair (15A, 15B) étant exécutés près des angles de la paroi et prévoyant une portion plate (19A, 19B) essentiellement formant une part de la plaque de fond (50), pendant que les renfoncements de la deuxième pair (17A, 17B) ont une portion plate (16A, 16B) parallèle à la plaque de fond, sur la dite portion plate étant prévus des ouvertures (51, 52) pour recevoir les moyens de clôture de deux éléments accouplés.

2. Elément comme sous 1, caractérisé en ce que deux portions creuses (61, 62) et deux portions érigées sont prévues sur la surface de la plaque de fond opposée à celle, sur laquelle s'élèvent les parois, et chacune des portions érigées est formée en correspondance d'un angle et opposée diagonalement.

3. Elément comme sous 1 ou 2, caractérisé en ce que le bord des deux renfoncements courbés (15A, 25B) diagonalement opposés à la dite première pair forme une rainure (55) avançant vers l'intérieur de l'élément en forme de plateau, pendant que le bord des deux autres renfoncements courbés (15B, 25A) forment une saillie complémentaire (56) du profile de milieu de la paroi placée à l'intérieur de l'élément à forme de plateau.

4. Elément comme sous 1, caractérisé en ce que les dites deux pairs de renfoncements courbés (15A, 15B, 17A, 17B et 25A, 25B, 27A, 27B) sont prévues sur les parois plus longs du plateau et en ce que entre les renfoncements courbés (17A, 17B) de la dite deuxième pair une saillie (12) et un renfoncement (11) sont prévus étant placés adjacents l'une à l'autre ayant la même longueur, et en ce que un autre renfoncement droite (13) ou respectivement une saillie droite (14) sépare chaque renfoncement courbé (17A, 17B) de la dite deuxième pair du renfoncement d'angle courbé correspondant (15A, 15B).

5. Elément comme sous 1, caractérisé en ce que sur chaque paroi plus courte une saillie (31, 41) et un renfoncement (32, 42) sont prévus, qui sont adjacents l'une à l'autre et de la même longueur, et à leur tour adjacents à un autre renfoncement droite (33, 43) ou respectivement à une saillie droite.

6. Elément comme sous 1, caractérisé en ce que les parois sont dotées de nervure de renforcement (18, 38), qui font face aux dites saillies.

7. Elément comme sous 2, caractérisé en ce que les dites portions (61, 62, 63, 64) ont la forme d'un secteur de cercle de 90°.

8. Elément comme sous 2, caractérisé en ce que sur la face opposée à celle où les parois latérales s'élèvent tout le bord périphérique du plateau est abaissé en correspondance d'un bord (66).
